# EUROPEAN PATENT APPLICATION

(11) **EP 4 432 418 A1**
(43) Date of publication of application: **18.09.2024**
(21) Application number: 23161610.3
(22) Date of filing: 13.03.2023
(51) Int. Cl.: H01M 10/42, G01R 31/36

(54) **TEST STAND FOR THE EVALUATION OF A MATERIAL INTENDED FOR USE IN A BATTERY AND TEST METHOD USING THE TEST STAND**

(71) Applicant: Henkel AG & Co. KGaA, 40589 Düsseldorf (DE)
(72) Inventor: KREISKOETHER, Kim Dana, 52146 Würselen (DE); FRANKEN, Uwe, 41542 Dormagen (DE); LEE, Keon Woo, 40489 Düsseldorf (DE); LAMMERSCHOP, Olaf, 47802 Krefeld (DE)
(74) Representative: Wagner Albiger & Partner Patentanwälte mbB

(57) **Abstract**

The invention relates to a test stand (1) for evaluating a material to be used in a battery under conditions which may occur during a thermal runaway, the test stand (1) comprising a honeycomb housing (10) with a hexagonal housing base (11), wherein in an inner space (15) of the housing (10) at least one activatable initiation cell (31) and a plurality of cylindrical battery cells (32, 33, 34, 35, 36) are arranged, the material to be evaluated being arranged in the inner space (15) or on the housing (10), the initiation cell (31) and the battery cells (32, 33, 34, 35, 36) being arranged in a honeycomb pattern in which a cell (30) which does not lie at the border of the honeycomb pattern has in each case six neighbouring cells which lie on the corners of an equilateral hexagon with a side length which corresponds to a distance A between cell (30) and neighbouring cell. The invention relates also to a test method using the test stand (1)

## Description

The invention relates to a test stand for evaluating a material that can be used in a battery under conditions that can occur during a thermal runaway.

Nowadays, high-voltage batteries are used in numerous applications, especially in connection with electromobility. For this purpose, individual battery cells are assembled into larger battery arrays. The individual battery cells, which are often designed as cylindrical battery cells, are arranged close together next to each other in a battery housing and connected in series and/or in parallel. Depending on the number and type of battery cells used, a battery can thus store an amount of energy that enables electric driving for several 100 km without intermediate charging.

A local short-circuit between the internal electrodes of a battery cell leads to a high short-circuit current that heats up the battery cell extremely quickly. Mechanical damage from the outside or thermal overheating, for example due to the failure of a battery cooling system, can also lead to extreme heating or thermal runaway of the battery cell. This thermal runaway of a battery cell can easily or quickly spread to neighbouring battery cells. This leads to a chain reaction, whereby the energy stored in the battery is released explosively. This explosive release of energy, which is also referred to as thermal propagation, can be accompanied by toxic gases and the formation of flames and sparks.

It is known from the prior art to provide a material with low thermal conductivity, high dielectric strength and high thermal (fire) resistance between the individual battery cells in order to reduce the risk of thermal propagation. For example, it is known from EP 3 753 056 B1 to embed the individual battery cells in a potting compound consisting of a polyurethane foam with a high proportion of flame retardant. The polyurethane foam should preferably have a flame resistance of level V0, measured according to the UL 94 test for the flammability of plastics.

The UL 94 test is performed with an open flame. The classification determined during the test (e.g. level V0) is of limited value with regard to the suitability of a material for use in a battery with the aim of avoiding thermal propagation as far as possible, as the test conditions differ significantly from the conditions in a battery. Therefore, materials such as the potting compound made of polyurethane are also tested in batteries in which thermal propagation of a battery cell is initiated. However, this is done in non-standard set-ups or methods, as each battery manufacturer uses its own battery design for the test stand. The test results of an initiated thermal runaway obtained in this way are therefore not directly comparable with each other.

The invention is therefore based on the object of providing a test stand for a material that can be used in a battery, which ensures a good balance between effort (costs, working time, test environment) and benefit with regard to the material evaluation in the event of a thermal runaway.

The object underlying the invention is achieved with the combination of features according to claim 1. Examples of embodiments of the invention can be taken from the subclaims to claim 1.

According to the invention, the test stand for evaluating a material to be used in the battery under conditions that may occur during a thermal runaway comprises a honeycomb-shaped housing with a hexagonal housing base, wherein at least one activatable initiation cell and a plurality of battery cells are located in an iinner space of the housing, and the material to be evaluated is arranged in the inner space or on the housing, wherein the initiation cell and the battery cells are arranged in a honeycomb pattern in which a cell not lying at the edge of the honeycomb pattern has six neighbouring cells each lying on the corners of an equilateral hexagon with a side length corresponding to a distance A between cell and neighbouring cell.

By arranging the battery cells in a honeycomb pattern, the influence of the thermal runaway of a cell on the surrounding neighbouring cells can be investigated in a very compact setup. The honeycomb pattern preferably extends parallel to the housing base, which should lie in an X-Y plane. Perpendicular to the X-Y plane, the battery cells may extend in a Z-direction. The battery cells preferably have a cylindrical shape with a longitudinal axis and a circular cross-section. A length L of the battery cell may be a factor of 3, 5 or even 7 greater than the greatest spatial dimension perpendicular to the longitudinal axis. In the case of a battery cell with a circular cross-section, the greatest spatial dimension perpendicular to the longitudinal axis corresponds to a diameter D.

In a preferred embodiment, the spatial dimensions of the battery cell correspond to the spatial dimensions of the initiation cell. For example, if the battery cell is a cylinder, the initiation cell can also be a cylinder with the same length and diameter D. This ensures a realistic test environment, as thermal propagation in a real battery originates from a (defective) battery cell, which is simulated in the test by the activatable initiation cell.

Due to the honeycomb pattern, the initiation cell has six neighbouring cells, each of which is arranged at the same distance A from the initiation cell. When the initiation cell is activated, all six neighbouring cells are therefore affected in the same way by the energy released by the initiation cell. In a preferred embodiment example, the initiation cell is arranged in the centre of the honeycomb pattern, wherein 6n n-th order battery cells with n = 1, 2, 3,.., N are provided around the initiation cell, and wherein a distance between the initiation cell and an n-th order battery cell corresponds to n times A. In one embodiment example, N is equal to 5, so that six first order battery cells, 12 second order battery cells, 18 third order batteries, 24 fourth order battery cells, and 30 fifth order battery cells are provided. The second order battery cells are arranged on an equilateral hexagon whose side length is equal to 2A. The 12 battery cells are arranged at the six corners of the hexagon and centrally between each of the six corners. The fifth order battery cells are located on an outermost hexagon with a side length of 5A. Together with the centrally arranged initiating cell, the honeycomb pattern of this embodiment thus has a total of 91 cells.

First tests have shown that battery cells of higher orders or additional battery cells whose distance from the initiation cell is greater than 5A are not affected by the thermal propagation emanating from the centrally located initiation cell. These additional battery cells therefore do not lead to any additional findings when evaluating the test results and can therefore be omitted for cost reasons. The honeycomb-shaped housing enables compact encasing of the honeycomb pattern. Of course, in dependance on the type of battery cells, the distance A between the battery cells and the materials tested in the test stand, more or less than 5 orders of batteries can be provided.

Theoretically, the thermal propagation in the X-Y plane continues uniformly in all directions, since the honeycomb pattern offers the same geometric conditions in all directions of the X-Y plane. This facilitates the evaluation of the test results obtained and allows comparative observations of the thermal propagation in the different directions.

The material to be evaluated, which is tested in the test bench, may be an insulating material, which may be provided between the individual battery cells. The insulating material may be a curable potting compound that is poured into the gaps between the battery cells. However, the material to be evaluated may also be the material surrounding channels of a battery cooling system that can be used to cool the individual battery cells. The material for embedding the channels of the battery cooling usually has a higher thermal conductivity than the thermal insulation material between the battery cells.

The housing may have six side walls extending vertically from the housing base towards an housing opening. The test stand may include a cover, with which the housing opening can be closed. Materials for a seal between the cover and the housing or a coating of the cover can also be examined with regard to their suitability in a battery by the test stand according to the invention.

The housing can be made from metal. Other materials for the housing, for instance plastic or reinforced plastic, are conceivable.

Pressure limitation means can be provided to limit the pressure prevailing in the inner space of the housing. During thermal runaway or thermal propagation, very high pressures can occur in the inner space, which can be limited, for example, by means of a pressure relief valve. Another and inexpensive version of pressure limitation means is a plug made of rock wool. Rock wool ensures continuous pressure equalisation and good thermal insulation, so that not too much heat is lost via the plug and a realistic replication of the conditions in a real battery is possible. The pressure limitation means can be attached to the housing and/or the cover.

A plate-shaped cell holder with several centring means, for example in the form of round holes, can be provided in the housing, through which the position of the initiation element and the position of the battery cells are determined. One cell is inserted into each hole so that the cell holder defines the honeycomb pattern. Preferably, the cell holder is located close to the housing base or rests on it. The cell holder is preferably hexagonal in its basic shape and can be inserted into the housing with little play. The plate-shaped cell holder can be made of plastic and produced by a 3D printer.

A metal plate may be provided at an end of the battery cells facing away from the base of the housing. The metal plate in the housing of the test stand is intended to represent the wiring or interconnection of the battery cells in a battery (busbar). Like the wiring/interconnection of the battery cells, the metal plate has a high thermal conductivity. The metal plate can have openings for receiving or fixing the battery cells.

Insofar as the focus is on the investigation of a thermal insulation material which is provided between two adjacent cells and thus allows a statement to be made with regard to the thermal propagation between the cells (cell to cell), the test stand according to the invention can also be used to investigate the thermal propagation between two battery modules (module to module). In a battery module, several battery cells are housed in a module carrier, whereby the module carrier additionally protects the battery cells located therein.

In one embodiment, a first group of cells are housed in a first module carrier and a second group of cells are housed in a second module carrier. The first module carrier may be provided with a trapezoidal carrier base having a longer base edge, a shorter base edge which is parallel to the longer base edge, and two legs. The length of the shorter base edge and the length of the legs correspond approximately to the length of one edge of the hexagonal housing base. The first module carrier can be placed in the inner space of the housing and covers approximately half of the hexagonal housing base when in the inserted position. The second module carrier, which is preferably identical in construction to the first module support, can also be positioned in the inner space so that the two longer base edges of the two module supports are opposite each other. One or more initiation cells can be arranged in one of the module carriers. The test stand can then be used to investigate the extent to which thermal propagation spreads from the module carrier with the initiation cells to the other module carrier.

At least two temperature sensors can be provided, which are arranged at different distances from the initiation cell in the inner space of the housing. The temperature sensor preferably records the temporal course of the temperature from the time of activation of the initiation cell. The comparison of the time courses of the differently positioned temperature sensors allows important conclusions to be drawn as to how the thermal propagation spreads in the interior. For example, several temperature sensors can be arranged in a row, whereby the first temperature sensor is arranged between the initiation element and a first order battery cell, the second temperature sensor between the first order battery cell and a second order battery cell, and so on.

In one embodiment, at least one of the temperature sensors projects vertically from below through an opening in the housing base, whereby its height in the inner space can be fixed by a screw connection. The height of the temperature sensor means the height at which the temperature is measured. If the temperature sensor is, for example, a thermocouple with a measuring tip, the height of the measuring tip corresponds to the height of the temperature sensor.

The test stand can have several feet on which the housing is supported so that a free space remains between the housing base and a ground on which the test stand stands. This free space can be used for the mounting and arrangement of the temperature sensors, which can protrude through the housing base from below.

A further object of the invention, the provision of a method for testing a material which can be used in a battery, is achieved by the combination of features according to claim 14.

The method of testing the material according to the invention includes the use of the test stand described herein, wherein the at least one initiation cell is activated to start the thermal runaway, wherein the temperatures measured by the at least two temperature sensors during the thermal runaway are recorded, and wherein after the test run the state of the individual battery cells and the time course (time cof the measured temperatures are evaluated.

The invention is explained in more detail with reference to the embodiments shown in the drawing. It is shown in:
- Figure 1: schematically a test stand according to the invention;
- Figure 2: the view along line II - II in figure 1;
- Figure 3: an arrangement of battery cells and an initiation cell;
- Figure 4: an alternative arrangement of battery cells and initiation cells in two module carriers;
- Figure 5: a further example of an embodiment in longitudinal section;
- Figure 6: an arrangement of battery cells, initiation cell and temperature sensors; and
- Figure 7: a housing base with holes for the temperature sensors.

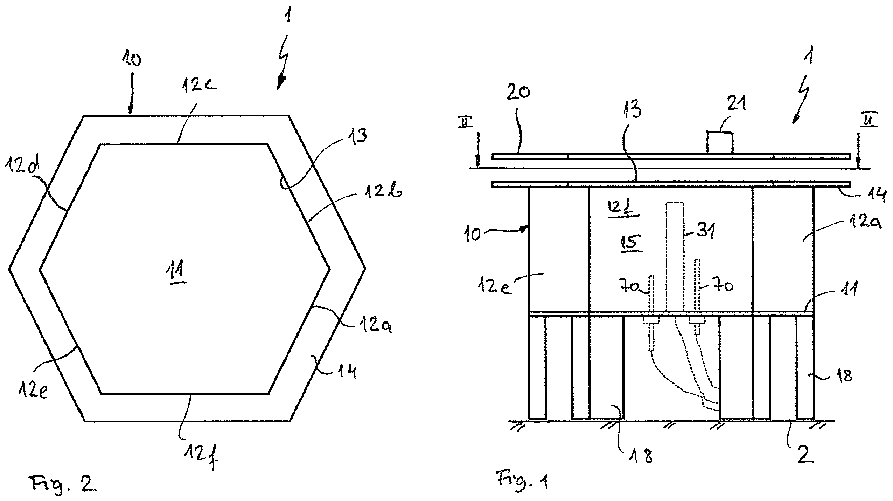

Figures 1 and 2 schematically show a test stand 1 with a metal housing 10 that has a hexagonal housing base 11. The basic shape of the hexagonal housing base 11 corresponds to an equilateral hexagon. The housing 10 has 6 side walls 12 (12a to 12e) which extend perpendicularly from the housing base 11 towards a housing opening 13. The housing opening 13 can be closed by a hexagonal cover 20. For fastening the cover 20, a housing flange 14 is provided on which the cover 20 rests flat when the housing opening 13 is closed. Not shown are fastening means, for example in the form of screws and nuts, by which the cover 20 and housing flange 14 can be firmly connected to each other. The cover 20 has a pressure relief valve 21 so that the pressure in an inner space 15 of the housing 10 is limited upwards. Additionally or alternatively, the pressure relief valve 21 can be attached to the housing base 11 or to one of the sidewalls 12.

In Figure 2, which represents the view along line II-II in Figure 1, the components that can be arranged in the inner space 15 of the housing 10 and are only indicated by dashed lines in Figure 1, are not shown.

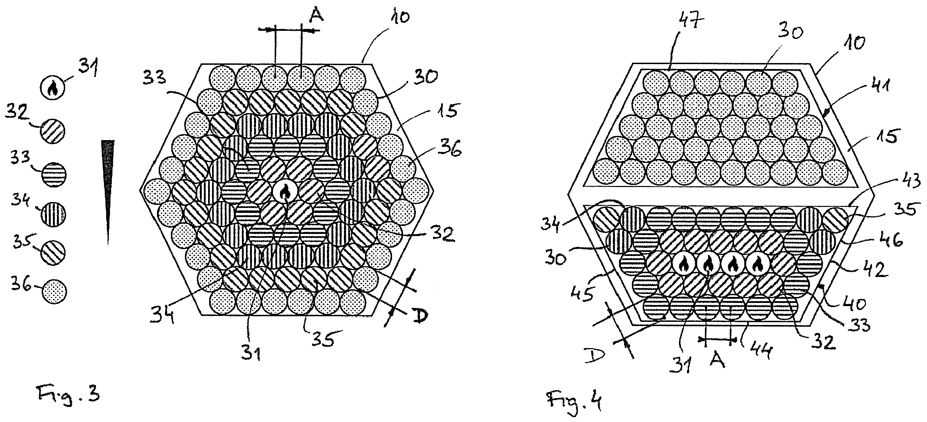

Figure 3 shows the housing 10 from above, whereby the housing flange 14 is not shown here. A number of cylindrical cells 30 are arranged in a honeycomb pattern in the housing 10. Each cell has the same diameter D.

A cylindrical initiation cell 31 is located in the centre of the honeycomb pattern. 6 neighbouring cells in the form of first order battery cells 32 are arranged around the initiation cell 31, which lie on the corners of an equilateral hexagon and each have a distance A from the initiation cell 31 (in the honeycomb pattern, all cells 30 have the distance A from their neighbouring cells). In this embodiment example, the distance A corresponds to the diameter D of the cells 30. The distance A may also be greater than the diameter D, so that adjacent cells 30 are spaced apart and a gap is created between them. For example, the distance A can be 1,0 to 1,3 times the diameter D.

Around the six first order battery cells 32, twelve second order battery cells 33, which are also arranged in a hexagon, are connected in a radial direction to the outside. The second order battery cells 33 are followed by third order battery cells 34, fourth order battery cells 35 and fifth order battery cells 36.

Energy can be supplied to the initiation cell 31 so that this cell heats up. This is to simulate a thermal runaway of this cell. The increased temperature in the initiation cell 31 also leads to thermal runaway in the first order battery cells 32, so that a chain reaction takes place in the honeycomb pattern and the other battery cells are also affected by this thermal propagation. The scale in Figure 3, left side, shows that the lower order battery cells are more affected by thermal propagation than the higher order battery cells.

With the test stand 1 and the cells 30 arranged in a honeycomb pattern, the influence of a material filled in the gaps between the cells on the thermal propagation can be investigated, for example. If it is a material with very low thermal conductivity and high thermal (fire) resistance, a simulated thermal runaway of the centrally arranged cell 30 (see initiation cell 31) will not damage all cells 30 of the honeycomb pattern in the same way, but, for example, the first order battery cells 32 and the second order battery cells 33 will be completely affected and the higher order battery cells will only be partially or slightly affected.

Figure 4 shows a housing 10 in whose inner space 15 a first battery module 40 and a second battery module 41 are accommodated. The first battery module 40 comprises a first tray-shaped module carrier 42 with a trapezoidal carrier base. The carrier base has a longer base edge 43, a shorter base edge 44 and two legs 45, 46 connecting the two mutually parallel base edges 43, 44. In the module carrier 42 of the first battery module 40, four initiation cells 31 are arranged in a row adjacent to each other. Twelve first-order battery cells 32 surrounds these four initiation cells 31. Again, the cells 30 are arranged in a honeycomb pattern which allows the cells 30 to be equally spaced from directly adjacent cells. Second, third and fourth order battery cells 33, 34, 35 are also arranged in the module carrier 42.

A second module carrier 47 of the second battery module 41 is identical in construction to the first module carrier 42 of the first battery module 40. Only cells 30 are arranged in the module carrier 47 of the second battery module 41 which, after a simulated thermal runaway in the first battery module 40, have been practically unaffected by thermal propagation. With this test setup, the protective effect of battery modules can be checked in the test stand according to the invention.

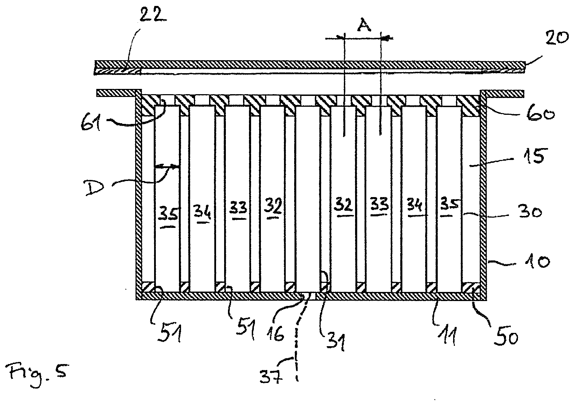

Figure 5 shows a longitudinal section of another embodiment in which the cells 30 are arranged in the inner space 15 of the housing 10, again in a honeycomb pattern with a central initiation cell 31. In addition to the central initiation cell 31, the honeycomb pattern comprises first order battery cells 32, second order battery cells 33, third order battery cells 34 and fourth order battery cells 35. A plate-shaped cell holder 50 rests on the housing base 11, in which a plurality of round openings 51 are provided. The openings 51 are arranged in a honeycomb pattern. The single battery cells 30 can be inserted into these openings 51 so that the plate-shaped cell holder 50 determines the position of the battery cells. The plate-shaped cell holder 50 can be made of plastic.

A metal plate 60 is provided at the end of each cell 30 remote from the base of the housing 11. The metal plate has a plurality of stepped apertures 61. The metal plate 60 is intended to simulate the wiring or metal interconnection of the individual cells 30 with each other. In the event of thermal propagation starting from a defective battery cell, a very large amount of heat can be transferred to the other cells 30, in particular via the thermally conductive metallic wiring. In the test stand according to the invention, this effect is simulated by the metal plate 60.

The cover 20 has a circumferential seal 22. This circumferential seal 32 can also be the subject of investigations to which extent the material of the circumferential seal 22 withstands the then prevailing conditions (temperature, pressure, fire resistance) during thermal propagation.

Figure 5 also shows that an opening 16 is provided in the housing base 11 through which a line 37 shown with a dashed line can activate or control the initiation cell 31.

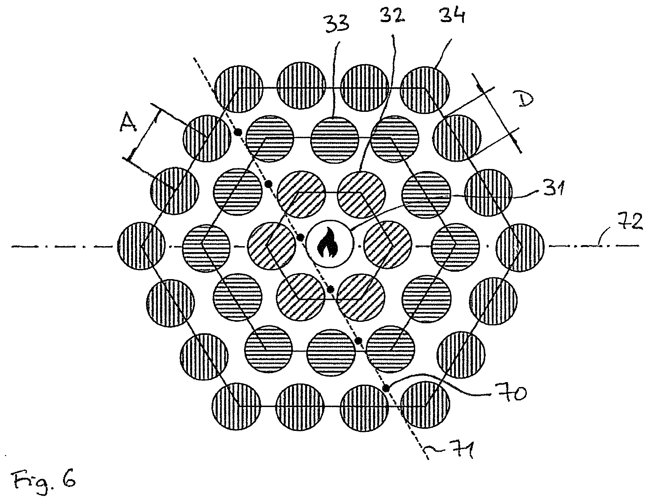

Figure 6 shows the cells 30 of Figure 5 in a honeycomb pattern from above. Here, too, it can be seen that the distance A between the longitudinal centre axes of two adjacent cells 30 is greater than the diameter D. Each battery cell of the same order can be assigned an equilateral hexagon on which the battery cells are arranged either on the corners or the sides of the hexagon. The hexagon of the first order batteries 32 has a side length of A. The side length of the hexagon of the n-th order battery cells is n times A (n = 1, 2, 3, 4). It is noted that Figures 5 and 6 are not true-to-scale representations. For instance, the distance A can be in the range of 1,02 to 1,07 times D.

Temperature sensors 70 are arranged in the gaps between the individual battery cells 30, which are arranged here on a straight line 71 and are at different distances from the initiation cell 31. Using the temperature sensors 70, which preferably record the temperature curve over time starting with the activation of the initiation cell 31, the thermal propagation can be measured as a function of time. Alternatively or additionally, the temperature sensors can also be arranged on other lines, for example on the dotted line 72, which incidentally represents the line of intersection with the longitudinal section of Figure 5.

Figure 1 shows that the temperature sensors can be arranged in such a way that they can measure the respective temperatures at different heights in relation to the plane of the housing base 11. This makes it possible to collect not only data relating to thermal propagation in the X-Y plane (plane parallel to the housing base 11), but also data for thermal propagation in the Z direction, i.e. perpendicular to the X-Y plane.

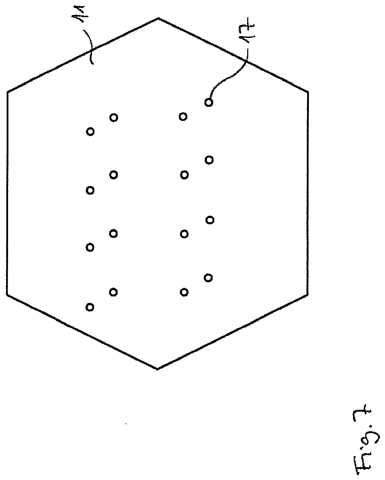

To position the temperature sensors 70, openings 17 (see Figure 7) can be provided in the base of the housing 11 through which the temperature sensors are inserted from below through the base of the housing 11 (see also Figure 1). The height of each temperature sensor 70 can be precisely adjusted by means of a screw connection, for example. The pattern of holes for temperature sensors shown in Figure 7 corresponds to a test setup as shown in Figure 4, in which the efficiency of battery modules is examined.

In order to leave a free space for the temperature sensors 70 between the housing base 11 and a ground 2 on which the test stand 1 stands, feet 18 are preferably provided at the corners of the hexagonal housing. Since high temperatures can develop in the housing 10 during a test, the feet 18 also ensure a necessary distance from the substrate 2 so that it is not damaged by the heat in the housing.

### List of reference signs

- 1: test stand
- 2: ground
- 10: housing
- 11: housing base
- 12: sidewall (12a to 12f)
- 13: housing opening
- 14: housing flange
- 15: inner space
- 16: opening
- 17: opening
- 18: foot
- 20: cover
- 21: pressure limitation means / pressure relief valve
- 22: seal
- 30: cell
- 31: initiation cell
- 32: first order battery cell
- 33: second order battery cell
- 34: third order battery cell
- 35: fourth order battery cell
- 36: fifth order battery cell
- 37: line
- 40: first battery module
- 41: second battery module
- 42: first module carrier
- 43: longer base edge
- 44: shorter base edge
- 45: leg
- 46: leg
- 47: second module carrier
- 50: cell holder
- 51: opening
- 60: metal plate
- 61: stepped opening
- 70: temperature sensor
- 71: straight line
- 72: straight line

## Claims

1. A test stand (1) for evaluating a material to be used in a battery under conditions which may occur during a thermal runaway, the test stand (1) comprising a honeycomb housing (10) with a hexagonal housing base (11), wherein in an inner space (15) of the housing (10) at least one activatable initiation cell (31) and a plurality of cylindrical battery cells (32, 33, 34, 35, 36) are arranged, the material to be evaluated being arranged in the inner space (15) or on the housing (10), the initiation cell (31) and the battery cells (32, 33, 34, 35, 36) being arranged in a honeycomb pattern in which a cell (30) which does not lie at the border of the honeycomb pattern has in each case six neighbouring cells which lie on the corners of an equilateral hexagon with a side length which corresponds to a distance A between cell (30) and neighbouring cell.

2. The test stand (1) according to claim 1, **characterized in that** the initiation cell (31) is arranged in the centre of the honeycomb pattern, and 6n n-th order battery cells (32, 33, 34, 35, 36) with n = 1, 2, 3,... are provided around the initiation cell (31), wherein a distance between the initiation cell (31) and an n-th order battery cell (32, 33, 34, 35, 36) corresponds to n times A.

3. A test stand (1) according to claim 1 or 2, **characterised in that** the housing (10) has six side walls (12) extending perpendicularly from the housing base (11) towards a housing opening (13).

4. Test stand (1) according to claim 3, **characterised in that** a cover (20) is provided with which the housing opening (13) can be closed.

5. Test stand (1) according to any one of claims 1 to 4, **characterised in that** pressure limitation means (21) are provided which limit the pressure prevailing in the inner space (15) of the housing (10).

6. A test stand (1) according to any one of claims 1 to 5, **characterised in that** a plate-shaped cell holder (50) having a plurality of centring means is provided in the housing (10), by means of which the position of the initiating element (31) and the position of the battery cells (32, 33, 34, 35, 36) are fixed.

7. Test stand (1) according to claim 6, **characterised in that** the cell holder (50) is arranged close to the housing base (11).

8. Test stand (1) according to any one of claims 1 to 7, **characterised in that** a metal plate (60) provided with openings (61) is provided at an end of the cells (30) facing away from the housing base (11).

9. A test stand (1) according to any one of claims 1 to 8, **characterized in that** a first group of cells is accommodated in a first module carrier (41) and a second group of cells is accommodated in a second module carrier (47).

10. A test stand (1) according to claim 9, **characterised in that** the first module carrier (41) has a trapezoidal carrier base with a longer base edge (43), a shorter base edge (44) which is parallel to the longer base edge (43), and with two legs (45, 46), the length of the shorter base edge (43) and the length of the legs (45, 46) approximately corresponding to the length of an edge of the hexagonal housing base (11).

11. Test stand (1) according to any one of claims 1 to 10, **characterised in that** at least two temperature sensors (70) are provided which are arranged at different distances from the initiation cell (31) in the inner space (15) of the housing (10).

12. Test stand (1) according to claim 3 and claim 11, **characterised in that** at least one of the temperature sensors (70) projects vertically upwards from below through an opening (17) in the housing base (11), the height of which can be fixed in the inner space (15) by a screw connection.

13. Test stand (1) according to any one of claims 1 to 12, **characterised in that** the housing (10) is supported on a plurality of feet (18) so that a free space remains between the housing base (11) and a ground (2) on which the test stand (1) stands with the feet (18).

14. Method for testing a battery component with a test stand (1) according to any one of claims 11 to 13, wherein the at least one initiation cell (31) is activated to start the thermal runaway, wherein the temperatures measured by the at least two temperature sensors (70) during the thermal runaway are recorded, and wherein after the thermal runaway the state of the individual battery cells (32, 33, 34, 35, 36) and the time curve of the measured temperatures are evaluated.

## Amended claims

### Amended claims in accordance with Rule 137(2) EPC.

1. A test stand (1) for evaluating a material to be used in a battery under conditions which may occur during a thermal runaway, the test stand (1) comprising a honeycomb housing (10) with a hexagonal housing base (11), wherein in an inner space (15) of the housing (10) at least one activatable initiation cell (31) and a plurality of cylindrical battery cells (32, 33, 34, 35, 36) are arranged, the material to be evaluated being arranged in the inner space (15) or on the housing (10), the initiation cell (31) and the battery cells (32, 33, 34, 35, 36) being arranged in a honeycomb pattern in which a cell (30) which does not lie at the border of the honeycomb pattern has in each case six neighbouring cells which lie on the corners of an equilateral hexagon with a side length which corresponds to a distance A between cell (30) and neighbouring cell, wherein the housing (10) has six side walls (12) extending perpendicularly from the housing base (11) towards a housing opening (13) which is closed with a cover (20) wherein a plate-shaped cell holder (50) being made of plastic and having a plurality of centring means is provided in the housing (10) and arranged close to the housing base(11), by means of which the position of the initiating element (31) and the position of the battery cells (32, 33, 34, 35, 36) are fixed, and wherein a metal plate (60) provided with openings (61) is provided in the housing at an end of the cells (30) facing away from the housing base (11).

2. The test stand (1) according to claim 1, **characterized in that** the initiation cell (31) is arranged in the centre of the honeycomb pattern, and 6n n-th order battery cells (32, 33, 34, 35, 36) with n = 1,2, 3,... are provided around the initiation cell (31), wherein a distance between the initiation cell (31) and an n-th order battery cell (32, 33, 34, 35, 36) corresponds to n times A.

3. Test stand (1) according to claim 1 or 2, **characterised in that** pressure limitation means (21) are provided which limit the pressure prevailing in the inner space (15) of the housing (10).

4. A test stand (1) according to any one of claims 1 to 3, **characterized in that** a first group of cells is accommodated in a first module carrier (41) and a second group of cells is accommodated in a second module carrier (47).

5. A test stand (1) according to claim 4, **characterised in that** the first module carrier (41) has a trapezoidal carrier base with a longer base edge (43), a shorter base edge (44) which is parallel to the longer base edge (43), and with two legs (45, 46), the length of the shorter base edge (43) and the length of the legs (45, 46) approximately corresponding to the length of an edge of the hexagonal housing base (11).

6. Test stand (1) according to any one of claims 1 to 5, **characterised in that** at least two temperature sensors (70) are provided which are arranged at different distances from the initiation cell (31) in the inner space (15) of the housing (10).

7. Test stand (1) according to claim 6, **characterised in that** at least one of the temperature sensors (70) projects vertically upwards from below through an opening (17) in the housing base (11), the height of which can be fixed in the inner space (15) by a screw connection.

8. Test stand (1) according to any one of claims 1 to 7, **characterised in that** the housing (10) is supported on a plurality of feet (18) so that a free space remains between the housing base (11) and a ground (2) on which the test stand (1) stands with the feet (18).

9. Method for testing a battery component with a test stand (1) according to any one of claims 6 to 8, wherein the at least one initiation cell (31) is activated to start the thermal runaway, wherein the temperatures measured by the at least two temperature sensors (70) during the thermal runaway are recorded, and wherein after the thermal runaway the state of the individual battery cells (32, 33, 34, 35, 36) and the time curve of the measured temperatures are evaluated.
